# FASCICULE DE BREVET EUROPEEN

(11) **EP 3 094 984 B1**
(45) Date de publication et mention de la délivrance du brevet: **29.11.2017**
(21) Numéro de dépôt: 15700578.6
(22) Date de dépôt: 16.01.2015
(51) Int. Cl.: H02J 3/38, H02J 7/00, B60L 11/18, G01R 31/36

(54) **PROCÉDÉ ET SYSTÈME DE GESTION D'UNE PLURALITÉ D'ENSEMBLE DE STOCKAGE D'ÉNERGIE.**
VERFAHREN UND SYSTEM ZUR VERWALTUNG EINER VIELZAHL VON ENERGIESPEICHERANORDNUNGEN
METHOD AND SYSTEM FOR MANAGING A PLURALITY OF ENERGY STORAGE ASSEMBLIES

(30) Priorité: 17.01.2014 FR 1450394
(43) Date de publication de la demande: 23.11.2016
(73) Titulaire: Blue Solutions, 29500 Ergué Gabéric (FR)
(72) Inventeur: LE PAVEN, Yvon, 29500 Ergue Gaberic (FR); BRUNET, Gilles, 29170 Ploneis (FR); SELLIN, Christian, 29900 Concarneau (FR); JESTIN, Jean-Jacques, 29170 Fouesnant (FR)
(74) Mandataire: Regimbeau
(86) Numéro de dépôt international: PCT/EP2015/050736
(87) Numéro de publication internationale: WO 2015/107136

(56) Documents cités:
- US-A1- 2012 104 861
- US-A1- 2013 113 437
- US-A1- 2014 009 117

## Description

L'invention a pour objet un système d'alimentation en énergie d'un objet, à l'aide d'une pluralité d'ensembles de stockage d'énergie et en particulier un procédé de gestion de la fourniture d'énergie par ces ensembles de stockage.

On connaît déjà des ensembles de stockage d'énergie, notamment des batteries, reliés en série ou en parallèle et destinés à alimenter un objet, un ou plusieurs convertisseurs de courant continu étant placés entre ces ensembles de stockage et l'objet à alimenter. L'énergie est transférée en cas de nécessité depuis les ensembles de stockage jusqu'à l'objet à alimenter, selon les demandes de l'objet. L'énergie provenant des ensembles étant généralement convertie de façon uniforme pour tous les ensembles, les ensembles étant commandés pour fournir l'énergie de façon uniforme à l'objet à alimenter.

On trouvera un exemple de dispositif connu dans le document US 2013/0113437.

Un tel système de fourniture relativement classique donne généralement satisfaction. Toutefois, dans certains cas, notamment lorsqu'on utilise un grand nombre d'ensembles de stockage d'énergie, par exemple pour alimenter en énergie une pluralité d'habitations, on s'aperçoit que la durée de vie de chacun des ensembles dans le système n'est alors pas aussi importante que lorsqu'on utilise les ensembles individuellement.

L'invention a ainsi pour objet d'améliorer la durée de vie d'un système de fourniture d'énergie tel que décrit ci-dessus.

A cet effet, l'invention a pour objet un procédé de gestion d'une pluralité d'ensembles de stockage d'énergie destinés à fournir de l'énergie électrique à un objet à alimenter tel que défini dans la revendication 1 annexée. De cette façon, tout en tenant compte des besoins de l'objet à alimenter, on adapte le fonctionnement du système en tenant compte des éventuelles spécificités de chaque ensemble de stockage. On gère en effet de façon personnalisée chacun des ensembles utilisé pour l'alimentation en énergie de l'objet, et on optimise ainsi la durée de vie de chacun des ensembles, permettant également d'augmenter la durée de vie du système.

En effet, il est fréquent que deux ensembles de stockage n'aient pas tout à fait le même comportement en fonctionnement. Ces différences, mineures lorsque les ensembles sortent des lignes de fabrication peuvent se creuser après un certain nombre de cycles de fonctionnement, entraînant alors la dégradation de l'un des ensembles. Cette dégradation peut engendrer un fonctionnement en surrégime des autres ensembles qui peuvent alors se dégrader plus rapidement que lorsqu'ils fonctionnent isolément. L'invention permet de remédier à cet inconvénient, notamment en prenant en compte les paramètres de tous les ensembles et non seulement ceux de l'ensemble concerné pour déterminer la consigne du convertisseur associée à l'ensemble.

L'invention permet donc d'obtenir un système de fourniture d'énergie dont la durée de vie est supérieure à ce qui est obtenu dans l'état de la technique. Elle permet également de ce fait d'élargir les dispersions de caractéristiques des ensembles choisis pour constituer le système, ces dispersions n'étant plus problématiques, même lorsque les ensembles fonctionnent ensemble.

Le procédé selon l'invention peut comprendre l'une ou plusieurs caractéristiques de la liste suivante :
- pour rappel, la consigne en sortie du convertisseur est la valeur imposée d'une grandeur électrique (notamment tension ou courant) au niveau du convertisseur ;
- un convertisseur distinct peut être associé à chaque ensemble de stockage. En variante, un même convertisseur peut être associé à plusieurs ensembles de stockage. Ledit convertisseur comprend alors plusieurs branches électriques en parallèle reliées chacune à un ensemble de stockage et un moyen de réglage de la grandeur électrique (type IGBT par exemple) par branche électrique. On notera également toutefois que si un convertisseur est relié électriquement à plusieurs ensembles de stockage, ces ensembles peuvent fonctionner soit tous dans le même mode (charge ou décharge), soit indépendamment les uns des autres. Ce dernier mode de réalisation permet un bon réglage individuel des ensembles de stockage sans pour autant augmenter les coûts de façon considérable. Le nombre d'ensembles par convertisseur est de préférence réduit, par exemple inférieur à cinq, ce qui permet tout de même une meilleure flexibilité du système, par exemple en cas de défaillance d'un convertisseur ;
- la puissance de sortie peut être une puissance prédéterminée et constante, notamment considérée comme suffisante pour alimenter l'objet, ou une puissance demandée par l'objet à alimenter à chaque instant, mesurée dans l'installation, et donc susceptible d'être variable ;
- on détermine au moins une caractéristique relative à l'ensemble en fonction du ou d'au moins l'un des paramètres mesurés, ladite ou lesdites caractéristiques relatives à un ensemble étant susceptibles d'être utilisées pour déterminer la consigne du convertisseur associée à au moins un autre ensemble. La ou l'au moins une des caractéristiques est un niveau d'énergie stockée dans l'ensemble et/ou une intensité de décharge admissible ;
- de préférence, chaque ensemble comprend une unité de mesure pour mesurer le ou les paramètres relatifs à l'ensemble et éventuellement des moyens de détermination de la ou de l'au moins une des caractéristiques relatives à l'ensemble. Ces paramètres mesurés peuvent en effet être utilisés pour gérer d'autres commandes internes à l'ensemble de stockage d'énergie et les inclure dans l'ensemble. Ce mode de réalisation permet donc de rassembler les fonctionnalités et d'éviter les coûts supplémentaires ;
- on commande également l'ensemble pour que l'intensité de décharge de celui-ci ne dépasse pas l'intensité de décharge admissible déterminée. Les moyens de commande pour ce faire peuvent être intégrés à l'ensemble ;
- au moins l'un des ensembles, notamment chaque ensemble, est susceptible de transmettre le ou au moins l'un des paramètres mesurés et/ou la ou au moins l'une des caractéristiques déterminées à une unité de traitement qui effectue l'étape de détermination des consignes des convertisseurs associés à chaque ensemble. Cette unité de traitement peut ainsi effectuer facilement, en possédant toutes les données nécessaires relatives aux ensembles, l'étape de détermination des consignes de sortie associées à chaque ensemble ;
- le procédé selon l'invention peut notamment comprendre les étapes suivantes :
   o lorsque la valeur du ou d'au moins un paramètre déterminé et/ou de la ou d'au moins une caractéristique déterminée associée à un ensemble, dit ensemble faible, est comprise dans une première fourchette de valeurs prédéterminée, on détermine la consigne du convertisseur associé audit ensemble uniquement en fonction des valeurs du ou des paramètres et/ou de la ou des caractéristiques relatifs à l'ensemble,
   o pour les ensembles dont la valeur du ou des paramètres déterminés et/ou de la ou les caractéristiques déterminées associées n'est pas comprise dans la première fourchette, dits ensembles forts, on détermine les consignes du ou des convertisseurs associées auxdits ensembles en fonction de la puissance de sortie et des consignes du ou des convertisseurs déterminées pour les ensembles faibles ;
   Les ensembles qui stockent moins d'énergie que ce qui est attendu (ou ensembles faibles) sont donc signalés et sont les seuls qui bénéficient d'un traitement particulier adapté. On peut leur demander moins de puissance mais en contrepartie, on demande aux autres ensembles une puissance accrue. En particulier, on détermine la puissance totale à transmettre par les ensembles de laquelle on soustrait la puissance susceptible d'être fournie par les ensembles faibles sans dégrader ceux-ci. La puissance ainsi déterminée est divisée par le nombre d'ensembles forts afin de déterminer la puissance que chacun doit fournir. Les consignes des convertisseurs sont ensuite réglées pour que chaque ensemble fort fournisse la même puissance. Cela permet d'égaliser les niveaux d'énergie des différents ensembles et ainsi de mieux gérer le système tout entier ;
- chaque ensemble transmet de préférence la valeur du ou des paramètres déterminés et/ou de la ou des caractéristiques déterminées à l'unité de traitement uniquement si la valeur de la caractéristique ou du paramètre est comprise dans la première fourchette. De cette façon, on évite les communications inutiles au sein du système et seuls les ensembles faibles sont signalés à l'unité de traitement pour que celle-ci puisse les prendre en compte. Alternativement, tous les ensembles transmettent leurs paramètres, par exemple toutes les secondes environ, notamment selon une synchronisation établie par l'unité de traitement. De cette façon, les collisions de données sont évitées ;
- l'ensemble est notamment dit « faible » si l'intensité de décharge admissible est inférieure à une valeur de seuil. L'intensité de décharge peut être déterminée à partir des paramètres mesurés et/ou d'autres caractéristiques relatives à l'ensemble, telle que le niveau d'énergie stockée dans celui-ci ;
- Un cas particulier qui peut être rencontré est le suivant : lorsque le niveau d'énergie stockée d'un ensemble est inférieur à une valeur de seuil, par exemple 5%, on détermine pour cet ensemble une intensité de décharge admissible nulle et on détermine ensuite une consigne du convertisseur associé à l'ensemble également nulle, à savoir par exemple qu'une consigne de tension en sortie est réglée à 0V, ce qui revient à déconnecter l'ensemble de stockage du reste du circuit électrique et notamment de l'objet à alimenter. Une telle intensité de décharge admissible nulle peut également être déterminée lorsque certaines alarmes classiques sont signalées au sein de l'ensemble de stockage, par exemple s'il est signalé que la température est inférieure à un certain seuil ou au contraire supérieure à un certain seuil, ce qui dénote une défaillance de l'ensemble de stockage ;
- le ou les paramètres mesurés (au sein de chaque ensemble) sont notamment compris dans la liste suivante :
   ∘ une intensité circulant dans l'ensemble, et/ou
   ∘ une tension aux bornes d'au moins une partie de l'ensemble, et/ou
   ∘ une température de l'ensemble ;
- lorsque la valeur du ou d'au moins un paramètre et/ou de la ou d'au moins une caractéristique associée à un ensemble est comprise dans une deuxième fourchette prédéterminée, on détermine la consigne du convertisseur associé à l'ensemble de sorte qu'une puissance non nulle soit transmise à l'ensemble, le convertisseur étant bidirectionnel. Ce paramètre, ou cette caractéristique vérifiée, peut être autre que celui comparé à la première fourchette de valeurs ou peut être le même, la deuxième fourchette de valeurs étant alors incluse dans la première fourchette ;
- en particulier, lorsque le niveau d'énergie d'un ensemble est inférieur à une valeur de seuil, par exemple 1%, on commande cet ensemble pour qu'il fonctionne en mode charge et on détermine une consigne du convertisseur associé à l'ensemble de sorte qu'une puissance non nulle soit transmise à l'ensemble. Cela permet d'éviter une décharge totale de l'ensemble. La puissance est transmise à l'ensemble notamment obtenue en transmettant une consigne en tension du convertisseur associé à cet ensemble supérieure à la tension nominale de l'ensemble, ce qui permet de charger l'ensemble. Cet ensemble peut alors être chargé à faible intensité à partir des autres ensembles de stockage, les autres ensembles restant toutefois en mode décharge ;
- chaque ensemble de stockage d'énergie est notamment un module de batterie comprenant au moins une cellule élémentaire, notamment une pluralité de cellules élémentaires en série. Chaque cellule comporte une anode, une cathode et un électrolyte, l'anode et la cathode échangeant des ions par le biais de l'électrolyte afin qu'une réaction d'oxydo-réduction se produise dans la cellule. Le module de batterie est de préférence de type lithium métal polymère avec un électrolyte réalisé en polymère et solide lorsque le module de batterie est au repos. Cette configuration augmente en effet la sécurité du module de batterie et sa durée de vie ;
- le cas du passage de la phase de décharge à la phase de charge effectué lorsqu'on mesure qu'une puissance d'entrée fournie par la source électrique est supérieure à une puissance de seuil, notamment la puissance de sortie, se produit notamment lorsque la source d'énergie est un moyen de génération d'énergie qui ne fournit pas de l'énergie en continu mais dépend par exemple pour cela des conditions climatiques;
- lors de la phase de charge :
   ∘ on mesure une puissance fournie par la source électrique et on détermine si la puissance disponible est suffisante pour charger les ensembles à une intensité de charge prédéterminée, et,
   ∘ si c'est le cas, on détermine une consigne du ou des convertisseurs associée à chaque ensemble choisie pour charger chaque ensemble à l'intensité de charge prédéterminée,
   ∘ sinon, on détermine une consigne du ou des convertisseurs associée à chaque ensemble choisie afin de charger chaque ensemble à la même puissance et on détermine au moins une grandeur de charge de l'ensemble, notamment une intensité de charge admissible, en fonction de cette consigne ;
   Dans cette phase de charge, comme expliqué auparavant, la consigne en tension du convertisseur est notamment réglée pour être supérieure à la tension de l'ensemble de stockage d'énergie. On règle là encore la consigne du convertisseur en fonction de l'élément électrique qui reçoit l'énergie à savoir l'ensemble de stockage. Lorsque suffisamment d'énergie est disponible, seuls les paramètres de l'ensemble peuvent être considérés pour déterminer la consigne associée.
   Toutefois, si la source d'énergie n'est pas suffisamment puissante, on effectue la charge égale de chacun des ensembles à faible courant plutôt que de privilégier la charge de certains, ce qui permet d'homogénéiser le système et d'augmenter ainsi sa durée de vie ;
- les ensembles de stockage d'énergie peuvent être reliés à deux sources d'énergie distinctes, notamment au travers du bus DC, l'une des sources d'énergie étant notamment un moyen de génération d'énergie alors que l'autre des sources est un réseau de distribution électrique. La source d'énergie principale est de préférence le moyen de génération d'énergie, et on connecte les ensembles (et l'objet à alimenter) à l'autre source d'énergie lorsque la puissance d'entrée fournie par la source principale et la puissance fournie par les ensembles en phase de décharge est inférieure à une puissance de seuil, notamment la puissance de sortie. Cela permet
- ainsi d'optimiser l'utilisation de l'installation puisque les objets à alimenter pourront toujours être alimentés, au moins par le biais du réseau électrique de secours. Ce réseau électrique de secours est toutefois relié seulement quand cela est réellement nécessaire aux ensembles et/ou à l'objet à alimenter.

L'invention a également pour objet un système de fourniture d'énergie à un objet à alimenter, tel que défini en revendication indépendante annexée.

Comme on l'a déjà indiqué, un convertisseur peut être placé en série de chaque ensemble de stockage d'énergie ou être interposé entre une pluralité d'ensembles de stockage et l'objet à alimenter. Quoi qu'il en soit le convertisseur est tout de même apte à appliquer une consigne différente pour chacun des ensembles avec lequel il est relié électriquement.

De préférence, les moyens de mesure sont ménagés au niveau de chaque ensemble, le système comprenant également une unité de traitement apte à communiquer avec tous les ensembles et comprenant les moyens de détermination de la consigne associée à chaque ensemble.

Dans ce cas, l'unité de traitement est de préférence également apte à communiquer avec les moyens de commande du ou des convertisseurs.

Les ensembles de stockage d'énergie étant reliés à au moins une source d'énergie, par l'intermédiaire du ou des convertisseurs et, ledit ou lesdits convertisseurs étant bidirectionnels, on peut charger ou décharger par le biais du ou des convertisseurs les ensembles de stockage d'énergie.

De façon optionnelle, les ensembles de stockage d'énergie sont reliés à deux sources d'énergie distinctes, l'une des sources d'énergie étant notamment un moyen de génération d'énergie alors que l'autre des sources est un réseau de distribution électrique.

Le système peut bien entendu comprendre également l'une ou plusieurs caractéristiques définies ci-dessus en relation avec le procédé.

On va maintenant décrire un exemple de réalisation nullement limitatif de l'invention à l'aide des figures détaillées ci-après, dans lesquelles :
- la figure 1 est un schéma électrique simplifié du système selon un mode de réalisation particulier de l'invention,

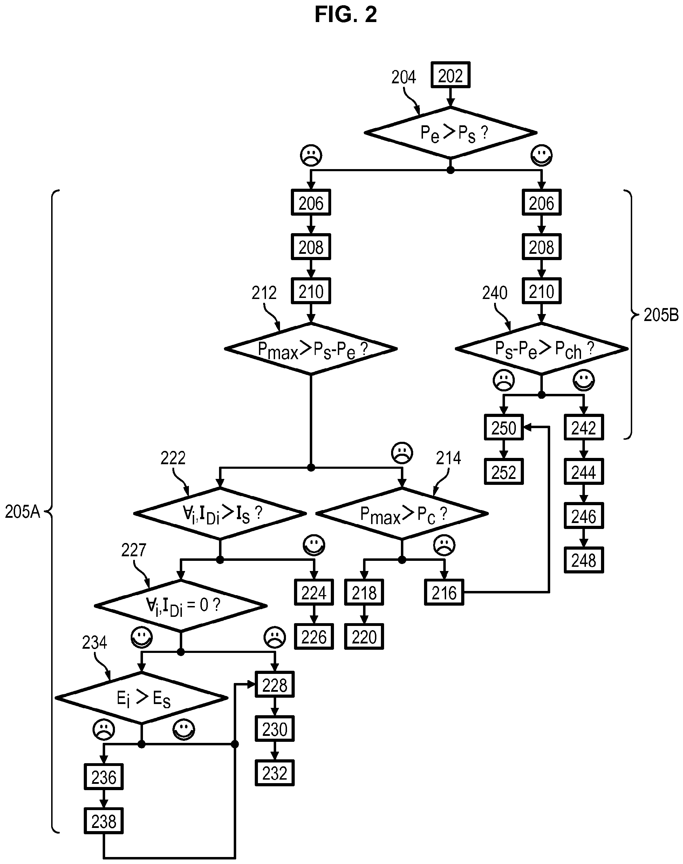

- la figure 2 est un diagramme d'un procédé de gestion du système de la figure 1 et notamment des ensembles de stockage selon un mode de réalisation particulier de l'invention.

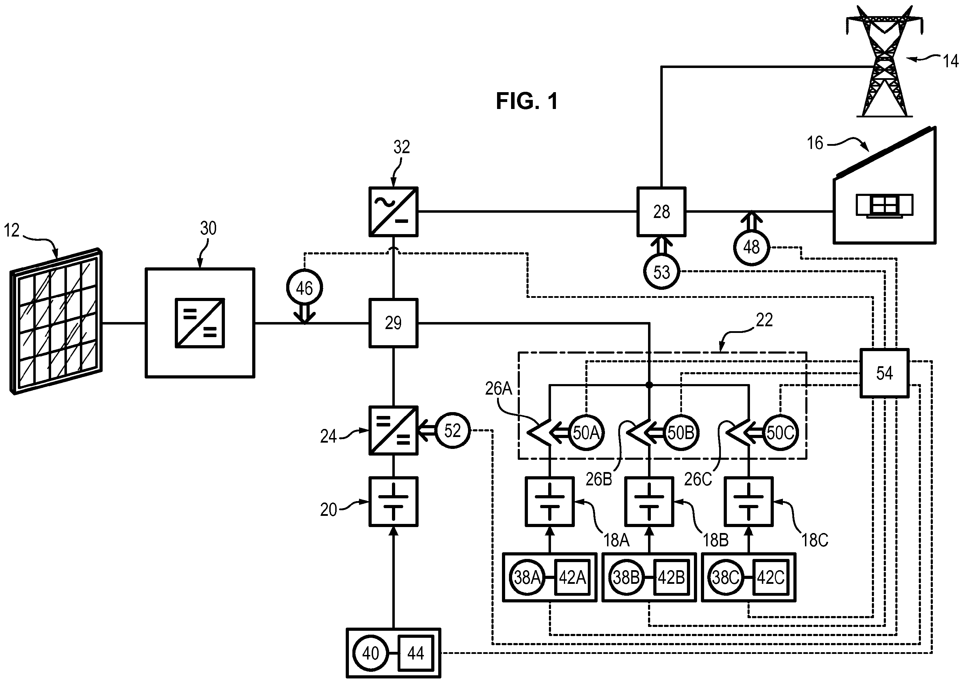

On a représenté sur la figure 1 un système 10 selon un mode de réalisation de l'invention.

Comme on le voit sur la figure, ce système comprend deux sources d'énergie distinctes, à savoir un moyen de génération d'énergie 12 à partir d'une source naturelle, ici représenté par un panneau photovoltaïque, et un réseau de distribution d'électricité 14. On notera que le moyen de génération d'énergie électrique 12 comprend en réalité bien entendu, lorsque l'énergie est d'origine solaire, bien plus d'un panneau, les panneaux pouvant être reliés en parallèle et/ou en série. Bien entendu, le moyen de génération d'énergie pourrait être un tout autre moyen, telle qu'une éolienne, une hydrolienne, etc. Le réseau de distribution d'électricité pourrait également être remplacé par un groupe électrogène.

Le système selon l'invention comprend également un objet à alimenter 16, ici représenté par une habitation mais qui pourrait être toute charge électrique, quelle que soit sa nature et la puissance électrique nécessaire pour l'alimenter. Le réseau 14 pourrait également être considéré comme un objet à alimenter mais ce n'est pas le cas dans le mode de réalisation qui est décrit ici.

Il comprend également des moyens de stockage d'énergie, comprenant une pluralité d'ensembles de stockage d'énergie 18A, 18B, 18C, 20, ici tous identiques et agencés en parallèle. Les ensembles de stockage d'énergie sont notamment des modules de batteries comportant généralement au moins une cellule élémentaire, et de préférence une pluralité de cellules élémentaires en série, chaque cellule comportant une cathode, une anode et un électrolyte afin qu'une réaction d'oxydo-réduction se produise au sein de chaque cellule élémentaire. Le module de batterie est de préférence de type au lithium et notamment de type lithium métal polymère, avec un électrolyte sous forme solide lorsque le module de batterie est au repos, ce qui permet d'améliorer la sécurité et la durée de vie du module. Bien entendu, le module pourrait toutefois être de tout autre type, par exemple lithium-ion. Les modules pourraient également ne pas tous être identiques, et notamment être de type différent et/ou présenter des capacités de stockage différentes. Le nombre et l'agencement des ensembles de stockage n'est pas non plus limité à ce qui a été décrit, certains ensembles pouvant par exemple être agencés en série.

Le système comprend également des convertisseurs de courant continu 22 et 24, agencés en série des ensembles de stockage. Plus particulièrement, le convertisseur 22 est interposé entre les ensembles de stockage 18A-18C d'une part et les sources électriques 12, 14 et l'objet à alimenter 16 d'autre part. Le convertisseur 24 est interposé entre l'ensemble de stockage 20 d'une part et les sources électriques 12,14 et l'objet à alimenter 16 d'autre part. Le courant de charge qui arrive dans chacun des ensembles de stockage (depuis les sources électriques) et le courant de décharge qui en est obtenu (pour alimenter l'objet 16) transite donc forcément par un convertisseur. Les convertisseurs sont de tout type connu et de préférence constitués par des hacheurs.

Comme on le voit sur la figure 1, les convertisseurs 22, 24 ne sont pas du même type. Le convertisseur 24 est destiné à être agencé en série d'un unique ensemble de stockage d'énergie 20 alors que le convertisseur 22 est agencé en amont de trois ensembles de stockage 18A-18C et est destiné à gérer ceux-ci. Il comprend pour ce faire trois branches électriques en parallèles comportant chacune un moyen de réglage permettant de régler une grandeur électrique spécifique à cette branche électrique, par exemple un interrupteur commandable de type transistor IGBT 26A-26C. Ainsi, on peut gérer chaque ensemble de stockage de façon individuelle, même si un unique convertisseur est placé en amont de trois ensembles de stockage.

Les convertisseurs 22, 24 fonctionnent comme des générateurs de tension qui appliquent une tension prédéterminée commandable et qui peut être distincte en amont de chaque ensemble de stockage. Ladite tension prédéterminée est la consigne de tension du convertisseur. On notera que les convertisseurs pourraient être également des générateurs de courant et on pourrait alors commander et appliquer une consigne de courant. Dans le mode de réalisation décrit, en fonction de la consigne en tension appliquée à chaque convertisseur ou à chaque branche du convertisseur, on peut charger ou décharger les batteries. La charge s'effectue notamment lorsque le convertisseur a une consigne de tension associée à l'ensemble de stockage plus élevée que la tension de l'ensemble de stockage et la décharge s'effectue lorsque le convertisseur a une consigne en tension associée à l'ensemble de stockage moins élevée que celle de l'ensemble de stockage.

Les convertisseurs ne sont pas limités à ce qui a été décrit. Ils pourraient en effet être placés en amont d'un nombre d'ensembles de stockage quelconque. Un seul convertisseur pourrait par exemple gérer les consignes de tension de tous les ensembles de stockage. Un convertisseur distinct pourrait à l'extrême inverse être utilisé par ensemble de stockage, comme cela est illustré avec l'ensemble 20. La première option permet une économie de coûts mais n'est pas très intéressante car les phases de charge et de décharge des ensembles associés à un même convertisseur doivent être gérées conjointement. Un bon compromis est de relier chaque convertisseur avec trois ensembles. Evidemment, cette option n'est pas la seule valide et de nombreuses configurations peuvent mener à des systèmes fonctionnels et permettant de remplir le but précité.

Comme on l'a indiqué auparavant, le groupe constitué des ensembles 18A-18C ; 20 et des convertisseurs 22-24 est relié électriquement d'une part aux sources électriques 12, 14 et d'autre part à l'objet à alimenter 16. Tous ces organes électriques sont reliés ensemble au travers d'un bus DC 29 qui permet de gérer l'énergie électrique en provenance de multiples sources de façon optimale et flexible en permettant notamment que certains ensembles de stockage soient en charge tandis que d'autres sont en décharge.

Le bus DC 29 est plus particulièrement relié d'une part aux panneaux solaires 12 et d'autre part au réseau de distribution électrique 14 auquel est également relié l'objet à alimenter 16. On notera également que des moyens d'interconnexion 28 sont prévus afin de connecter le bus DC29 au réseau 14 et/ou à l'objet à alimenter 16 ainsi que l'objet à alimenter 16 au réseau 14.

Interposés entre la source électrique 12 et le bus DC29 d'une part et le réseau 14, l'objet 16 et le bus DC29 d'autre part, le système comprend également un convertisseur, respectivement 30 et 32, permettant d'adapter l'énergie électrique fournie par chacune des sources électriques 12, 14 à une énergie apte à charger les ensembles de stockage 18A-18C ; 20. On notera que les ensembles de stockage d'énergie stockent l'énergie sous forme continue.

Le convertisseur 30 situé en aval des panneaux photovoltaïques 12 est notamment un chargeur comprenant un convertisseur de courant continu, les panneaux produisant également l'énergie sous forme continue. Le chargeur est notamment de type MPPT (acronyme de Maximum Puissance Point Tracking en anglais, soit « Recherche du Point de Puissance Maximum ») dans lequel le convertisseur adapte sa consigne en tension en fonction de la puissance produite par les panneaux lorsqu'il applique cette consigne, ces panneaux étant des générateurs non linéaires qui ne produisent pas la même puissance en fonction de la tension à laquelle ils génèrent l'énergie électrique. Le convertisseur est bien entendu adapté à la source électrique, un convertisseur en aval d'une éolienne qui produit un courant de type alternatif serait par exemple un convertisseur de courant alternatif/continu ou redresseur.

Le convertisseur 32 situé en aval du réseau 14 et auquel est également connecté l'objet à alimenter est un convertisseur AC/DC bilatéral, transformant l'énergie produite sous forme alternative en énergie sous forme continue et vice-versa, le réseau distribuant le courant sous une forme alternative et l'objet à alimenter utilisant également le courant sous cette forme. On notera que le réseau et le convertisseur associé sont des moyens de génération d'énergie de secours qui devraient en théorie ne pas être utilisés lors du fonctionnement normal du système et sont présents dans le système uniquement pour pallier des dysfonctionnements de certains éléments de ce système. Le système selon l'invention pourrait donc être conçu sans la branche électrique comprenant le réseau 14. En variante, l'objet à alimenter peut également être le réseau général de distribution électrique qui alimente alors les ensembles de stockage lorsqu'il y a un surplus d'énergie électrique relativement à la puissance demandée dans le réseau, l'énergie étant restituée au réseau lorsque la puissance produite par ailleurs dans le réseau n'est pas suffisante.

Le système comprend également des moyens de mesure 38A, 38B, 38C, 40 relatifs à chaque ensemble de stockage 18A, 18B, 18C, 20, ces moyens de mesure étant destinés à mesurer au moins un paramètre relatif à chaque ensemble de stockage. Ces paramètres sont en particulier la température de l'ensemble de stockage, un courant circulant dans au moins une partie de l'ensemble et/ou une tension aux bornes d'au moins une partie de l'ensemble. Ces moyens comprennent des capteurs ad hoc connus et sont généralement intégrés à l'ensemble de stockage d'énergie. Les paramètres mesurés par les moyens de mesure peuvent être ensuite analysés par des moyens d'analyse respectivement 42A, 42B, 42C, 44 comprenant notamment des moyens de détermination d'au moins une caractéristique, telle qu'un niveau de charge de la batterie ou une consigne de courant de décharge, à partir des paramètres mesurés.

Ces moyens d'analyse sont de préférence également intégrés à l'ensemble de stockage d'énergie et permettent une bonne gestion de l'ensemble de stockage. Ils font partie d'un élément intégré appelé BMS (Battery Management System en anglais, soit « Système de Gestion d'une Batterie ») et destiné à gérer l'ensemble de stockage auquel il est associé. Un tel dispositif effectue notamment des tests sur des paramètres mesurés et/ou des caractéristiques déterminées à partir des paramètres mesurés et lorsque les tests retournent des résultats anormaux, effectuent des actions pour limiter les conséquences du dysfonctionnement. Par exemple, lorsque la température de l'ensemble de stockage n'est pas comprise dans une fourchette prédéterminée, les moyens d'analyse peuvent commander des moyens d'interconnexion tels qu'un fusible pour déconnecter l'ensemble de stockage du reste du circuit. On notera donc que des moyens de commande peuvent être intégrés aux moyens d'analyse.

En variante, les moyens de mesure et/ou d'analyse pourraient être extérieurs à l'ensemble de stockage même s'il comporte un élément tel qu'une BMS, ce qui serait tout de même moins avantageux en termes de coûts. Les moyens d'analyse sont optionnels ou pourraient être intégrés à d'autres composants du système, notamment à l'unité de traitement 54 décrite ci-après.

Le système comprend également des moyens de mesure 46 situés dans la branche électrique de la source électrique 12 et permettant de mesurer la puissance d'entrée que ladite source 12 est apte à fournir. Ces moyens de mesure 46 peuvent notamment comprendre des moyens de mesure de la tension et de l'intensité dans cette branche électrique, notamment en sortie du chargeur MPPT 30.

Il peut également comprendre des moyens de mesure 48 situés dans la branche électrique de l'objet à alimenter 16 et permettant de mesurer la puissance de sortie demandée par l'objet à alimenter. Ces moyens de mesure 48 peuvent notamment comprendre des moyens de mesure de la tension et de l'intensité dans cette branche électrique. En variante, le système peut ne pas comprendre ces moyens de mesure mais la puissance de sortie peut être prédéterminée en fonction des besoins connus de l'objet à alimenter.

Le système comprend également des moyens de commande 50A, 50B, 50C, 52 des convertisseurs, ces moyens de commande permettant de commander l'application d'une consigne en tension prédéterminée en association avec chacun des ensembles. Les moyens 50A, 50B, 50C commandent en particulier les moyens de réglage 26A, 26B, 26C situé chacun sur une branche électrique du convertisseur 22. Le système comprend également des moyens de commande 53 des moyens d'interconnexion 28.

Le système comprend également une unité de traitement 54 en communication avec tous les moyens de mesure et d'analyse décrits plus haut. Cette unité de traitement 54 comprend notamment des moyens de stockage de données pour stocker les paramètres et/ou caractéristiques qu'elle reçoit des différents organes du système ainsi que des moyens d'exécution, tels qu'un processeur, qui lui permettent de déterminer les consignes en tension associées à chacun des ensembles à partir des paramètres mesurés et/ou des caractéristiques déterminées transmis par les ensembles de stockage d'énergie.

On va maintenant décrire le fonctionnement du système et notamment le procédé 200 de gestion des ensembles de stockage d'énergie selon un mode de réalisation de l'invention.

On mesure tout d'abord les puissances respectives d'entrée et de sortie du système, à l'aide des moyens respectifs 46, 48, lors d'une étape 202. On compare ensuite ces deux puissances, par le biais de l'unité de traitement 54 notamment, lors d'une étape 204. Si la puissance fournie en entrée Pe est inférieure à la puissance de sortie Ps, cela signifie que la puissance fournie par la source électrique 12 n'est pas suffisante pour alimenter l'objet à alimenter. On doit alors obtenir de l'énergie supplémentaire, par le biais des ensembles de stockage d'énergie, et on choisit donc de décharger les ensembles de stockage d'énergie vers l'objet à alimenter. L'unité de traitement 54 envoie donc aux ensembles de stockage d'énergie la consigne de se mettre en mode décharge (phase de décharge 205A). En revanche, si la puissance d'entrée Pe est supérieure à la puissance de sortie Ps, cela signifie que les panneaux photovoltaïques fournissent suffisamment d'énergie en provenance de la source pour alimenter l'objet 16 et qu'il reste de l'énergie disponible dans le système. On cherche donc à stocker cette énergie et on choisit de charger les ensembles de stockage d'énergie. L'unité de traitement 54 envoie donc aux ensembles de stockage d'énergie la consigne de se mettre en mode charge (phase de charge 205B).

### Phase de décharge :

Dans le cas où l'on est en phase de décharge, les moyens de mesure respectifs 38A-38C, 40 de chaque ensemble de stockage 18A-18C, 20 mesurent les paramètres relatifs à l'ensemble de stockage, à savoir notamment la température et la tension aux bornes de l'ensemble, lors d'une étape 206. Les moyens d'analyse respectifs 42A-42C, 44 déterminent ensuite certaines caractéristiques de l'ensemble de stockage, telle que le niveau de charge et l'intensité admissible de décharge, également appelée consigne de limitation de courant, de chaque ensemble de stockage lors d'une étape 208. Les moyens d'analyse 42A-42C, 44 commandent alors notamment l'ensemble de stockage pour que l'intensité de décharge ne dépasse pas la valeur de la consigne. Les différents paramètres et caractéristiques sont transmis à l'unité de traitement 54 lors d'une étape 210.

L'unité de traitement 54 est donc apte à calculer à l'aide des tensions et consignes de limitation en courant de chaque ensemble de stockage 18A-18C, 20 la puissance disponible aux bornes de chaque ensemble et la puissance maximale Pmax pouvant être fournie par les ensembles (somme des puissances de chaque ensemble) et compare cette puissance Pmax à la puissance nécessaire pour alimenter l'objet 16, soit (Ps-Pe), lors d'une étape 212.

Si la puissance Pmax n'est pas supérieure à (Ps-Pe), on compare Pmax à une autre puissance de seuil inférieure dite critique Pc, lors d'une étape 214. Si la puissance Pmax est inférieure à la puissance critique Pc, cela signifie que le système ne suffira pas à alimenter l'objet 16 et on commande les moyens d'interconnexion 28 et les ensembles de stockage par le biais de l'unité de traitement 54 et des moyens de commande 53 pour que le système soit relié au réseau de secours 14. En particulier, les moyens d'interconnexion 28 sont commandés pour que le courant en provenance de réseau puisse alimenter à la fois les ensembles de stockage et l'objet à alimenter. Les ensembles de stockage peuvent alors également être alimentés par les panneaux solaires. Les ensembles de stockage sont également commandés par les moyens d'analyse 42A-42C, 44 respectifs pour passer en mode charge.

Dans le cas contraire, les moyens d'interconnexion 28 sont commandés de sorte que l'objet à alimenter soit relié au bus DC 29 et éventuellement au réseau 14 mais le bus DC29 n'est alors pas relié au réseau 14.

Si la puissance Pmax est supérieure à Pc, on considère que le système est suffisant pour alimenter l'objet à alimenter mais que l'on est obligé d'utiliser la puissance maximale de chacun des ensembles et, lors d'une étape 218, l'unité de traitement 54 détermine les consignes de tension associées à chacun des ensembles en fonction uniquement des caractéristiques des ensembles, à savoir pour que l'ensemble correspondant se décharge à l'intensité de décharge admissible vers l'objet à alimenter 16. Les convertisseurs 22, 24 sont ensuite commandés lors d'une étape 220 pour appliquer les consignes déterminées, par le biais des moyens 50A-50C, 52. Bien entendu, les consignes de tension seront inférieures aux tensions respectives mesurées des ensembles de stockage, étant donné que ces ensembles sont en mode décharge.

Si au contraire, la puissance Pmax est supérieure à (Ps-Pe), l'unité de traitement 54 vérifie pour chacun des ensembles 18A-18C, 20 si la consigne de limitation en courant I_{D18A}, I_{D18B}, I_{D18C}, I_{D20} est supérieure à une valeur de seuil Is, lors d'une étape 222. Si c'est le cas, on considère que chaque ensemble de stockage fonctionne normalement. On souhaite alors appliquer une décharge uniforme de tous les ensembles. L'unité de traitement 54 calcule ainsi les consignes de tension associées à chacun des ensembles qu'il faut appliquer aux convertisseurs 22, 24 pour parvenir à ce résultat. Les consignes associées à chacun des ensembles 18A-18C, 20 sont notamment les mêmes. Lors d'une étape 226, les moyens de commande 50A-50C, 52 appliquent aux convertisseurs ces consignes.

Si en revanche, la consigne de limitation en courant associée à un ou plusieurs ensembles de stockage est inférieure à la valeur de seuil Is, ces ensembles étant dits « faibles », on ménage ces ensembles pour éviter leur détérioration. Un cas particulier est lorsque les moyens d'analyse de l'ensemble déterminent que la consigne de limitation en courant est de 0A, notamment parce que le niveau de charge de l'ensemble est inférieur à 5%. L'unité de traitement teste, lors d'une étape 227, si la consigne de limitation en courant associée à un ensemble donné est nulle.

Si ce n'est pas le cas, l'unité de traitement 54 calcule, lors d'une étape 228, pour chacun de ces ensembles « faibles », une consigne en tension associée à ceux-ci qui est uniquement fonction des caractéristiques de l'ensemble, de sorte que ledit ensemble se décharge à un courant correspondant à son courant de décharge admissible. Lors d'une étape 230, elle calcule ensuite la puissance restant à distribuer (Ps-Pe-puissance fournie par chacun des ensembles faibles), et la consigne en tension associée aux ensembles non identifiés comme « faibles » est calculée de sorte que chacun des ensembles non « faibles » fournissent la même puissance. Les consignes des ensembles non « faibles » sont donc égales et rattrapent les défaillances des ensembles faibles. Lors d'une étape 232, les moyens de commande 50A-50C, 52 appliquent aux convertisseurs ces consignes ainsi déterminées.

Si un des ensembles « faibles » a en revanche transmis à l'unité une consigne en limitation en courant nulle, l'unité de traitement 54 vérifie lors d'une étape 234 si l'énergie stockée Ei dans l'ensemble « faible » considéré est inférieure à une énergie de seuil Es, par exemple une énergie de 1%. Si ce n'est pas le cas, on applique les étapes 228 à 232, l'ensemble ayant une consigne de limitation de courant nulle étant de par la valeur de son intensité de décharge admissible déconnecté de l'objet à alimenter. On applique alors également au convertisseur une consigne de tension nulle en association avec l'ensemble considéré. On notera que la consigne de courant est appliquée à l'ensemble une fois que la consigne de tension a été appliquée au convertisseur.

Si en revanche, l'énergie Ei de l'ensemble de stockage est inférieure à l'énergie de seuil Es, il est préférable de le charger à très faible courant pour éviter qu'il ne se décharge complètement. Lors d'une étape 236, l'unité commande le passage de l'ensemble de stockage correspondant en phase de charge par le biais des moyens d'analyse de l'ensemble alors que les autres ensembles restent en phase de décharge. Elle détermine également une consigne de tension associée à cet ensemble pour obtenir sa charge au courant demandé et calcule la puissance générée par la charge lors d'une étape 238. Elle effectue ensuite les étapes 228 à 232 en calculant que la puissance restant à distribuer est augmentée de la puissance utilisée pour maintenir l'ensemble chargé.

Ce procédé est appliqué en temps réel durant toute la phase de décharge : les consignes de limitation de courant en provenance des ensembles sont susceptibles d'être modifiées en cours de décharge, et les consignes transmises aux convertisseurs étant également modifiées en conséquence.

### Phase de charge :

Si lors de l'étape de test initial 204, on détermine que les ensembles 18A-18C, 20 doivent être en mode charge, on effectue les étapes de mesure, de détermination et de transmission 206 à 210 déjà indiquée en phase de décharge.

On teste ensuite, lors d'une étape 240, à partir des données obtenues lors des étapes 202, 206 et 208, si la puissance dédiée à la charge des ensembles (Ps-Pe) est supérieure à une puissance de charge Pch correspondant à la charge de tous les ensembles à une intensité nominale. La puissance Pch est déterminée également à l'aide des informations relatives à la tension de chaque ensemble.

Si cette puissance n'est pas supérieure à la puissance de charge, on détermine les consignes associées à chaque ensemble au niveau des convertisseurs de sorte que la charge des ensembles soit effectuée uniformément et que la puissance soit répartie uniformément sur les différents ensembles lors d'une étape 242. On commande les moyens de commande 50A-50C, 52 lors d'une étape 244 pour qu'ils appliquent ladite consigne. On transmet également, lors d'une étape 246, à chaque ensemble la consigne transmise au convertisseur et chaque ensemble adapte, par le biais de ses moyens d'analyse 42A-42C, 44, la consigne de limitation en courant de charge appliquée à l'ensemble, lors d'une étape 248.

Si la puissance disponible pour la charge des ensembles 18A-18C, 20 est en revanche supérieure à la puissance de charge, la charge est effectuée de façon classique, à savoir qu'une consigne de tension est déterminée par l'unité de traitement 54 uniquement en fonction des caractéristiques de l'ensemble, notamment de sorte que l'ensemble soit chargé au courant nominal, lors d'une étape 250. Puis lors d'une étape 252, les convertisseurs 22, 24 sont commandés par le biais des moyens de commande 50A-50C, 52 pour appliquer les consignes calculées par l'unité de traitement.

Comme indiqué plus haut, dans cette phase de charge, les consignes en tension appliquées en association avec un ensemble de stockage sont forcément plus élevées que la tension de l'ensemble.

Si l'énergie électrique provient du réseau 14, on considère que la puissance disponible est forcément supérieure à la puissance de charge et on passe donc de l'étape 216 directement à l'étape 250.

Ainsi, le procédé tel que décrit permet de s'adapter aux dispersions des ensembles de stockage d'énergie afin de prolonger la vie des ensembles de stockage même lorsqu'ils fonctionnent conjointement avec d'autres ensembles.

Le procédé n'est toutefois pas limité à ce qui a été décrit. De nombreuses étapes sont optionnelles telle que l'étape de vérification du niveau de charge de l'ensemble de stockage. Les puissances choisies pour les seuils peuvent également être différentes de ce qui a été indiqué. Certaines étapes peuvent également varier en fonction de la configuration du système, par exemple si les moyens de détermination sont intégrés à l'unité de traitement et non à l'ensemble de stockage. L'ensemble pourrait également transmettre à l'unité de traitement la consigne de limitation en courant seulement lorsqu'elle est inférieure à une certaine limite.

De nombreuses autres modifications non décrites dans la demande peuvent également faire partie de l'invention, tant que ces modifications entrent dans le cadre des revendications.

## Revendications

1. Procédé (200) de gestion d'une pluralité d'ensembles de stockage d'énergie (18A-18C, 20) destinés à fournir de l'énergie électrique à un objet à alimenter (16) lors d'une phase de décharge (205A), les ensembles de stockage étant reliés électriquement en parallèle, au moins un convertisseur de courant continu (22, 24) étant interposé entre les ensembles de stockage d'énergie et l'objet à alimenter, de sorte que l'énergie en provenance de chaque ensemble de stockage est convertie de façon indépendante de celle provenant des autres ensembles, où, lors de la phase de décharge :
- on mesure (206) au moins un paramètre relatif à chaque ensemble de stockage,
- en fonction des paramètres mesurés pour tous les ensembles et d'au moins une puissance de sortie relative à l'objet à alimenter, on détermine (218, 224, 228, 230) pour le ou chaque convertisseur au moins une consigne relative à une grandeur électrique respective en sortie, de sorte qu'une consigne distincte soit associée à chacun des ensembles,
- on commande (220, 226, 232) le ou les convertisseurs pour que la consigne correspondante soit appliquée,
et dans lequel les ensembles de stockage d'énergie (18A-18C, 20) sont reliés à au moins une source d'énergie (12, 14), par l'intermédiaire du ou des convertisseurs (22, 24), le procédé comprenant une étape de commande des convertisseurs et des ensembles pour le passage de la phase décharge (205A) à une phase de charge (205B),
le procédé étant **caractérisé en ce que**, ledit ou lesdits convertisseurs sont bidirectionnels et le passage de la phase de décharge à la phase de charge est effectué lorsqu'on mesure qu'une puissance d'entrée (Pe) fournie par la source électrique est supérieure à une puissance de seuil notamment la puissance de sortie (Ps)

2. Procédé (200) selon la revendication précédente, dans lequel au moins un convertisseur (22) comprend une pluralité de branches électriques en parallèle reliées chacune à un ensemble de stockage d'énergie (18A-18C), chaque branche électrique comprenant un moyen de réglage (26A-26C) de la grandeur électrique spécifique à ladite branche.

3. Procédé (200) selon l'une des revendications précédentes, dans lequel on commande (208) également l'ensemble de stockage de sorte que son intensité ne dépasse pas une intensité de décharge admissible.

4. Procédé (200) selon l'une quelconque des revendications précédentes, dans lequel chaque ensemble (18A-18C, 20) comprend une unité de mesure (38A-38C, 40) pour mesurer le ou les paramètres relatifs à l'ensemble et éventuellement des moyens de détermination (42A-42C, 44) de la ou de l'au moins une des caractéristiques relative à la puissance admissible pour cet ensemble.

5. Procédé (200) selon l'une quelconque des revendications précédentes, dans lequel au moins l'un des ensembles (18A-18C, 20), notamment chaque ensemble, est susceptible de transmettre (210) le ou l'au moins un des paramètres mesurés et/ou au moins une caractéristique déterminée à une unité de traitement (54) qui effectue l'étape de détermination (216, 224, 228, 230) des consignes des convertisseurs (22, 24) associées à chacun des ensembles.

6. Procédé selon la revendication précédente, dans lequel :
- lorsque la valeur du ou d'au moins un paramètre déterminé et/ou de la ou d'au moins une caractéristique déterminée (I_{D18A}, I_{D18B}, I_{D18C}, I_{D20}) associée à un ensemble, dit ensemble faible, est comprise dans une première fourchette de valeurs prédéterminée, on détermine (228) la consigne du convertisseur associée audit ensemble uniquement en fonction de la valeur des paramètres et/ou caractéristiques associés à l'ensemble,
- pour les ensembles dont la valeur du ou des paramètres mesurés et/ou de la ou des caractéristiques déterminées associées n'est pas comprise dans la première fourchette, dits ensembles forts, on détermine (230) les consignes du ou des convertisseurs associées auxdits ensembles en fonction d'une puissance de sortie et des consignes du ou des convertisseurs déterminées pour les ensembles faibles.

7. Procédé selon l'une quelconque des revendications précédentes, dans lequel l'ensemble est dit faible si l'intensité de décharge admissible (I_{D18A}, I_{D18B}, I_{D18C}, I_{D20}) est inférieure à une valeur de seuil (Is).

8. Procédé selon l'une quelconque des revendications précédentes, dans lequel le ou les paramètres mesurés sont compris dans la liste suivante :
- une intensité circulant dans l'ensemble, et/ou
- une tension aux bornes d'au moins une partie de l'ensemble, et/ou
- une température de l'ensemble.

9. Procédé selon l'une quelconque des revendications précédentes, dans lequel, lorsque la valeur du ou d'au moins un paramètre et/ou de la ou d'au moins une caractéristique associée à un ensemble est comprise dans une deuxième fourchette prédéterminée, on détermine (238) la consigne du convertisseur associée à l'ensemble, de sorte qu'une puissance non nulle soit transmise à l'ensemble, le ou chaque convertisseur étant bidirectionnel.

10. Procédé selon la revendication précédente, dans lequel, lorsque le niveau d'énergie d'un ensemble est inférieur à une valeur de seuil, par exemple 1%, on commande cet ensemble pour qu'il fonctionne en mode charge (236) et on détermine (238) une consigne de sortie du convertisseur associée à l'ensemble de sorte qu'une puissance non nulle soit transmise à l'ensemble.

11. Procédé selon l'une des revendications précédentes, dans lequel, lors de la phase de charge (205B) :
- on mesure (202) une puissance fournie par la source électrique et on détermine (240) si la puissance disponible est suffisante pour charger les ensembles (18A-18C, 20) à une intensité de charge prédéterminée, et,
- si c'est le cas, on détermine (250) une consigne du ou des convertisseurs associée à chaque ensemble choisie pour charger chaque ensemble à une intensité de charge prédéterminée,
- sinon, on détermine (242) une consigne du ou des convertisseurs associée à chaque ensemble choisie afin de charger chaque ensemble à la même puissance et on détermine (248) au moins une grandeur de charge de l'ensemble, notamment une intensité de charge admissible, en fonction de cette consigne.

12. Procédé selon l'une des revendications précédentes, dans lequel les ensembles de stockage d'énergie (18A-18C, 20) sont reliés à deux sources d'énergie distinctes (12, 14), l'une des sources d'énergie étant notamment un moyen de génération d'énergie (12) alors que l'autre des sources est un réseau de distribution électrique (14).

13. Procédé selon la revendication précédente, dans lequel, la source d'énergie principale étant le moyen de génération d'énergie (12), on connecte les ensembles à l'autre source d'énergie (14) lorsque la puissance d'entrée (Pe) fournie par la source principale et la puissance fournie par les ensembles (Pmax) en phase de décharge est inférieure à une puissance de seuil (Pc), notamment la puissance de sortie.

14. Système (10) de fourniture d'énergie à un objet à alimenter, le système comprenant une pluralité d'ensembles de stockage d'énergie (18A-18C, 20) destinés à fournir de l'énergie à l'objet à alimenter (16) dans une phase de décharge, les ensembles de stockage étant reliés électriquement en parallèle, au moins un convertisseur de courant continu (22, 24) étant interposé entre les ensembles de stockage d'énergie et l'objet à alimenter, de sorte que l'énergie en provenance de chaque ensemble de stockage est convertie de façon indépendante de celle provenant des autres ensembles, dans lequel les ensembles de stockage d'énergie (18A-18C, 20) sont reliés à au moins une source d'énergie (12, 14), par l'intermédiaire du ou des convertisseurs (22, 24), le système comprenant également :
- des moyens de mesure (38A-38C, 40) d'au moins un paramètre relatif à chaque ensemble de stockage,
- des moyens de détermination (54) d'une consigne relative à une grandeur électrique en sortie du ou des convertisseurs associée à chacun des ensembles en fonction des paramètres mesurés par tous les moyens de mesure et d'une puissance de sortie (Ps) relative à l'objet à alimenter,
- des moyens de commande (50A-50C, 52) du ou de chaque convertisseur (22, 24) pour que les consignes respectives soient appliquées aux convertisseurs,
le système étant **caractérisé en ce que**, ledit ou lesdits convertisseurs sont bidirectionnels et le passage de la phase de décharge à la phase de charge est effectué lorsqu'on mesure qu'une puissance d'entrée (Pe) fournie par la source électrique est supérieure à une puissance de seuil notamment la puissance de sortie (Ps).

15. Système selon la revendication précédente, dans lequel les moyens de mesure (38A-38C, 40) sont ménagés au niveau de chaque ensemble (18A-18C, 20), le système comprenant également une unité de traitement (54) apte à communiquer avec tous les ensembles et comprenant les moyens de détermination de la consigne associée à chaque ensemble.

16. Système selon la revendication précédente, dans lequel l'unité de traitement (54) est apte à communiquer avec les moyens de commande (50A-50C, 52) des convertisseurs (22, 24).

17. Système selon l'une des revendications 14 à 16, dans lequel les ensembles de stockage d'énergie (18A-18C, 20) sont reliés à deux sources d'énergie distinctes (12, 14), l'une des sources d'énergie étant notamment un moyen de génération d'énergie (12) alors que l'autre des sources est un réseau de distribution électrique (14).

## Patentansprüche

1. Verwaltungsverfahren (200) einer Vielzahl von Energiespeichergruppen (18A-18C, 20), die dazu bestimmt sind, einem zu versorgenden Objekt (16) in einer Entladungsphase (205A) elektrische Energie zu liefern, wobei die Speichergruppen parallel elektrisch angeschlossen sind, wenigstens ein Gleichstromrichter (22, 24) zwischen den Energiespeichergruppen und dem zu versorgenden Objekt derart zwischengeschaltet ist, dass die aus jeder Speichergruppe stammende Energie unabhängig von der konvertiert wird, die aus den anderen Gruppen stammt, wobei in der Entladungsphase:
- wenigstens ein für jede Speichergruppe relativer Parameter gemessen wird (206);
- in Abhängigkeit der für alle Gruppen und wenigstens eine Ausgangsleistung relativ zu dem zu versorgenden Objekt gemessenen Parametern für den oder jeden Richter wenigstens ein Sollwert relativ zu einer jeweiligen elektrischen Größe am Ausgang derart bestimmt wird (218, 224, 228, 230), dass jeder Gruppe ein unterschiedlicher Sollwert zugeordnet wird;
- der oder die Richter gesteuert wird / werden (220, 226, 232), damit der entsprechende Sollwert angewendet wird;
und bei dem die Energiespeichergruppen (18A-18C, 20) über den oder die Richter (22, 24) an wenigstens eine Energiequelle (12, 14) angeschlossen sind, wobei das Verfahren einen Steuerschritt der Richter und der Gruppen für den Übergang von der Entladephase (205A) in eine Ladephase (205B) umfasst,
wobei das Verfahren **dadurch gekennzeichnet ist, dass** der genannte oder die genannten Richter bidirektional ist / sind und der Übergang von der Entladungsphase zur Ladephase durchgeführt wird, wenn eine von der Stromquelle gelieferte Eingangsleistung (Pe) höher ist als eine Schwellenleistung, insbesondere die Ausgangsleistung (Ps).

2. Verfahren (200) gemäß dem voranstehenden Anspruch, bei dem wenigstens ein Richter (22) eine Vielzahl von elektrischen Zweigen umfasst, die jeweils parallel an eine Energiespeichergruppe (18A-18C) angeschlossen sind, wobei jeder elektrische Zweig ein Einstellmittel (26A-26C) der für den genannten Zweig spezifischen elektrischen Größe umfasst.

3. Verfahren (200) gemäß einem der voranstehenden Ansprüche, bei dem ebenfalls die Speichergruppe derart gesteuert wird (208), dass ihre Intensität eine zulässige Entladeintensität nicht übersteigt.

4. Verfahren (200) gemäß irgendeinem der voranstehenden Ansprüche, bei dem jede Gruppe (18A-18C, 20) eine Maßeinheit (38A-38C, 40) zum Messen des oder der Parameter relativ zur Gruppe und eventuell der Bestimmungsmittel (42A-42C, 44) des oder des wenigstens einen Merkmals relativ zu der für diese Gruppe zulässigen Leistung umfasst.

5. Verfahren (200) gemäß irgendeinem der voranstehenden Ansprüche, bei dem wenigstens eine der Gruppen (18A-18B, 20), insbesondere jede Gruppe, geeignet ist, den oder den wenigstens einen der gemessenen Parameter und / oder wenigstens ein an einer Verarbeitungseinheit (54) bestimmtes Merkmal zu übertragen (210), die den Bestimmungsschritt (216, 224, 228, 230) der jeder Gruppe zugeordneten Sollwerte der Richter (22, 24) durchführt.

6. Verfahren gemäß dem voranstehenden Anspruch, bei dem:
- wenn der Wert des oder des wenigstens eines bestimmten Parameters und / oder des oder des wenigstens einen bestimmten Merkmals (I_{D18A}, I_{D18B}, I_{D18C}, I_{D20}), das einer Gruppe, bezeichnet als schwache Gruppe, zugeordnet ist, in einem ersten vorbestimmten Wertebereich inbegriffen ist, der Sollwert des Richters bestimmt (228) wird, der der genannten Gruppe nur in Abhängigkeit von dem Wert der Parameter und / oder den der Gruppe zugeordneten Merkmalen zugeordnet ist,
- bei den Gruppen, deren Wert des oder der gemessenen Parameter(s) und / oder des oder der zugeordneten, bestimmten Merkmals / Merkmale nicht in dem ersten Bereich, bezeichnet als starke Gruppen, inbegriffen ist, die Sollwerte des oder der Richter, die den genannten Gruppen in Abhängigkeit von einer Ausgangsleistung zugeordnet sind, und die Sollwerte des oder der für die schwachen Gruppen bestimmten Richters / Richter bestimmt werden (230).

7. Verfahren gemäß irgendeinem der voranstehenden Ansprüche, bei dem die Gruppe als schwach bezeichnet wird, wenn die Intensität der zulässigen Entladung (I_{D18A}, I_{D18B}, I_{D18C}, I_{D20}) geringer ist als ein Schwellenwert (Is).

8. Verfahren gemäß irgendeinem der voranstehenden Ansprüche, bei dem der oder die gemessene(n) Parameter in der folgenden Liste inbegriffen ist / sind:
- eine in der Gruppe umlaufende Intensität und / oder
- eine Spannung an den Anschlüssen von wenigstens einem Teil der Gruppe und / oder
- eine Temperatur der Gruppe.

9. Verfahren gemäß irgendeinem der voranstehenden Ansprüche, bei dem, wenn der Wert des oder des wenigstens einen Parameters und / oder des oder des wenigstens einen, einer Gruppe zugeordneten Merkmals in einem zweiten vorbestimmten Bereich inbegriffen ist, der Sollwert des der Gruppe zugeordneten Richters derart bestimmt wird (238), dass eine Leistung ungleich Null auf die Gruppe übertragen wird, wobei der oder jeder Richter bidirektional ist.

10. Verfahren gemäß dem voranstehenden Anspruch, bei dem, wenn das Energieniveau einer Gruppe unter einem Schwellenwert, z. B. 1 % liegt, diese Gruppe gesteuert wird, damit sie im Lademodus (236) arbeitet, und ein der Gruppe zugeordneter Ausgangssollwert des Richters derart bestimmt wird (238), dass auf die Gruppe eine Leistung ungleich Null übertragen wird.

11. Verfahren gemäß irgendeinem der voranstehenden Ansprüche, bei dem in der Ladephase (205B):
- eine von der Stromquelle gelieferte Leistung gemessen wird (202) und bestimmt wird (240), ob die verfügbare Leistung ausreichend ist, um die Gruppen (18A-18C, 20) mit einer vorbestimmten Ladeintensität zu laden, und
- wenn das der Fall ist, ein Sollwert des oder der Richter bestimmt wird (250), der jeder Gruppe zugeordnet und ausgewählt ist, um jede Gruppe mit einer vorbestimmten Lastintensität zu laden,
- andernfalls ein Sollwert des oder der Richter bestimmt wird (242), der jeder Gruppe zugeordnet und ausgewählt ist, um jede Gruppe mit derselben Leistung zu laden und wenigstens eine Ladegröße der Gruppe, insbesondere eine zulässige Lastintensität, in Abhängigkeit von diesem Sollwert bestimmt wird (248).

12. Verfahren gemäß irgendeinem der voranstehenden Ansprüche, bei dem die Energiespeichergruppen (18A-18C, 20) an zwei unterschiedliche Energiequellen (12, 14) angeschlossen sind, wobei eine der Energiequellen insbesondere ein Energieerzeugungsmittel (12) ist, während die andere der Quellen ein Stromnetz (14) ist.

13. Verfahren gemäß dem voranstehenden Anspruch, bei dem, wenn die Hauptenergiequelle das Energieerzeugungsmittel (12) ist, die Gruppen an die andere Energiequelle (14) angeschlossen werden, wenn die von der Hauptquelle gelieferte Eingangsleistung (Pe) und die von den Gruppen (Pmax) in der Entladungsphase gelieferte Leistung niedriger sind als eine Schwellenleistung (Pc), insbesondere die Ausgangsleistung.

14. System (10) zur Lieferung von Energie für ein zu versorgendes Objekt, wobei das System eine Vielzahl von Energiespeichergruppen (18A-18C) umfasst, die dazu bestimmt sind, dem zu versorgenden Objekt (16) Energie in einer Entladungsphase zu liefern, wobei die Speichergruppen elektrisch parallel angeschlossen sind, wobei wenigstens ein Gleichstromrichter (22, 24) zwischen den Energiespeichergruppen und dem zu versorgenden Objekt derart zwischengeschaltet ist, dass die aus jeder Speichergruppe stammende Energie unabhängig von der aus den anderen Gruppen stammenden konvertiert wird, bei dem die Energiespeichergruppen (18A-18C, 20) über den oder die Richter (22, 24) an wenigstens eine Energiequelle (12, 14) angeschlossen sind, wobei das System ebenfalls umfasst:
- Messmittel (38A-38C, 40) wenigstens eines Parameters relativ zu jeder Speichergruppe,
- Bestimmungsmittel (54) eines Sollwertes relativ zu einer elektrischen Größe am Ausgang des oder der Richter(s), der jeder Gruppe in Abhängigkeit von den von allen Messmitteln gemessenen Parametern zugeordnet ist und einer Ausgangsleistung (Ps) relativ zu dem zu versorgenden Objekt,
- Steuermittel (50A-50C, 52) des oder jedes Richters (22, 24), damit die jeweiligen Sollwerte auf die Richter angewendet werden,
wobei das System **dadurch gekennzeichnet ist, dass** der genannte oder die genannten Richter bidirektional ist / sind und der Übergang der Entladungsphase zur Ladephase ausgeführt wird, wenn gemessen wird, dass eine von der Stromquelle gelieferte Eingangsleistung (Pe) höher ist als eine Schwellenleistung, insbesondere die Ausgangsleistung (Ps).

15. System gemäß dem voranstehenden Anspruch, bei dem die Messmittel (38A-38C, 40) an jeder Gruppe (18A-18C, 20) angeordnet sind, wobei das System ebenfalls eine Verarbeitungseinheit (54) umfasst, die geeignet ist, mit allen Gruppen zu kommunizieren und Bestimmungsmittel des jeder Gruppe zugeordneten Sollwertes umfasst.

16. System gemäß dem voranstehenden Anspruch, bei dem die Verarbeitungseinheit (54) geeignet ist, mit den Steuermitteln (50A-50C, 52) der Richter (22, 24) zu kommunizieren.

17. System gemäß einem der Ansprüche 14 bis 16, bei dem die Energiespeichergruppen (18A-18C, 20) an zwei unterschiedliche Energiequellen (12, 14) angeschlossen sind, wobei eine der Energiequellen insbesondere ein Energieerzeugungsmittel (12) ist, während die andere Quelle ein Stromnetz (14) ist.

## Claims

1. A method (200) for managing a plurality of energy storage assemblies (18A-18C, 20) intended to supply electrical energy to an object to be fed (16) during a discharge phase (205A), the storage assemblies being electrically connected in parallel, at least one direct current converter (22, 24) being interposed between the energy storage assemblies and the object to be fed, such that the energy from each storage assembly is converted independently from that from the other assemblies, where, during the discharge phase:
- at least one parameter related to each storage assembly is measured (206),
- depending on the parameters measured for all the assemblies and at least one output power related to the object to be fed, for the or each converter, at least one set point related to a respective electrical quantity is determined (218, 224, 228, 230) at the output, such that a distinct set point is associated with each of the assemblies,
- the converter(s) is (are) controlled (220, 226, 232) such that the corresponding set point is applied,
and wherein the energy storage assemblies (18A-18C, 20) are connected to at least one energy source (12, 14), through the converter(s) (22, 24), the method comprising a step of controlling the converters and the assemblies for switching the discharge phase (205A) to a charge phase (205B),
the method being **characterised in that** said converter(s) is (are) bidirectional and switching from the discharge phase to the charge phase is performed when an input power (Pe) supplied by the electrical power source is measured higher than a threshold power in particular the output power (Ps).

2. The method (200) according to the preceding claim, wherein at least one converter (22) comprises a plurality of electrical branches in parallel each connected to an energy storage assembly (18A-18C), each electrical branch comprising a means (26A-26C) for setting the electrical quantity specific to said branch.

3. The method (200) according to one of the preceding claims, wherein the storage assembly is also controlled (208) such that its intensity does not exceed a permissible discharge intensity.

4. The method (200) according to any of the preceding claims, wherein each assembly (18A-18C, 20) comprises a measuring unit (38A-38C, 40) for measuring the parameter (s) related to the assembly and on the possibly means (42A-42C, 44) for determining the or at least one of the characteristics related to the permissible power for this assembly.

5. The method (200) according to any of the preceding claims, wherein at least one of the assemblies (18A-18C, 20), in particular each assembly, is likely to transmit (210) the or the at least one of the measured parameters and/or at least one determined characteristic to a processing unit (54) which performs the step (216, 224, 228, 230) of determining the set points of the converters (22, 24) associated with each of the assemblies.

6. The method according to the preceding claim, wherein:
- when the value of the or at least one determined parameter and/or the or at least one determined characteristic (I_{D18A}, I_{D18B}, I_{D18C}, I_{D20}) associated with an assembly, called a weak assembly, lies in a first predetermined range of values, the set point of the converter associated with said assembly is determined (228) only depending on the value of the parameters and/or characteristics associated with the assembly,
- for the assemblies the value of the measured parameter(s) and/or the associated determined characteristic (s) of which does not lie in the first range, called strong assemblies, the set points of the converter(s) associated with said assemblies are determined (230) depending on an output power and the set points of the converter(s) which are determined for the weak assemblies.

7. The method according to any of the preceding claims, wherein the assembly is called a weak assembly if the permissible discharge intensity (I_{D18A}, I_{D18B}, I_{D18C}, I_{D20}) is lower than a threshold value (Is).

8. The method according to any of the preceding claims, wherein the parameter(s) measured is (are) comprised in the following list:
- an intensity flowing in the assembly, and/or
- a voltage across at least one part of the assembly, and/or
- a temperature of the assembly.

9. The method according to any of the preceding claims, wherein, when the value of the or at least one parameter and/or the or at least one characteristic associated with an assembly lies in a second predetermined range, the set point of the converter associated with the assembly is determined (238), such that a non-zero power is transmitted to the assembly, the or each converter being bidirectional.

10. The method according to the preceding claim, wherein, when the energy level of an assembly is lower than a threshold value, for example 1%, this assembly is controlled such that it operates in a charge mode (236) and an output set point of the converter associated with the assembly is determined (238) such that a non-zero power is transmitted to the assembly.

11. The method according to one of the preceding claims, wherein, during the charge phase (205B):
- a power supplied by the electrical power source is measured (202) and it is determined (240) whether the available power is sufficient to charge the assemblies (18A-18C, 20) at a predetermined charge intensity, and
- if so, a set point of the converter (s) associated with each assembly chosen to charge each assembly at a predetermined charge intensity is determined (250),
- otherwise, a set point of the converter(s) associated with each assembly chosen in order to charge each assembly at the same power is determined (242) and at least one charge quantity of the assembly is determined (248), in particular a permissible charge intensity, depending on this set point.

12. The method according to one of the preceding claims, wherein the energy storage assemblies (18A-18C, 20) are connected to two distinct energy sources (12, 14), one of the energy sources being in particular an energy generating means (12) whereas the other of the sources is an electrical distribution grid (14).

13. The method according to the preceding claim, wherein, the main energy source being the energy generating means (12), the assemblies are connected to the other energy source (14) when the input power (Pe) supplied by the main source and the power supplied by the assemblies (Pmax) in the discharge phase is lower than a threshold power (Pc), in particular the output power.

14. A system (10) for supplying energy to an object to be fed, the system comprising a plurality of energy storage assemblies (18A-18C, 20) intended to supply energy to the object to be fed (16) in a discharge phase, the storage assemblies being electrically connected in parallel, at least one direct current converter (22, 24) being interposed between the energy storage assemblies and the object to be fed, such that the energy from each storage assembly is converted independently from that from the other assemblies, wherein the energy storage assemblies (18A-18C, 20) are connected to at least one energy source (12, 14), through the converter(s) (22, 24), the system also comprising:
- means (38A-38C, 40) for measuring at least one parameter related to each storage assembly,
- means (54) for determining a set point related to an electrical quantity at the output of the converter(s) associated with each of the assemblies depending on the parameters measured by all the measuring means and an output power (Ps) related to the object to be fed,
- means (50A-50C, 52) for controlling the or each converter (22, 24) such that the respective set points are applied to the converters,
the system being **characterised in that**, said converter(s) is (are) bidirectional and switching from the discharge phase to the charge phase is performed when an input power (Pe) supplied by the electric source is measured higher than a threshold power in particular the output power (Ps).

15. The system according to the preceding claim, wherein the measuring means (38A-38C, 40) are provided at each assembly (18A-18C, 20), the system also comprising a processing unit (54) able to communicate with all the assemblies and comprising the means for determining the set point associated with each assembly.

16. The system according to the preceding claim, wherein the processing unit (54) is able to communicate with the means (50A-50C, 52) for controlling the converters (22, 24).

17. The system according to one of claims 14 to 16, wherein the energy storage assemblies (18A-18C, 20) are connected to two distinct energy sources (12, 14), one of the energy sources being in particular an energy generating means (12) whereas the other of the sources is an electrical distribution grid (14).
